# EUROPEAN PATENT APPLICATION

(11) **EP 4 546 424 A1**
(43) Date of publication of application: **30.04.2025**
(21) Application number: 22969011.0
(22) Date of filing: 23.12.2022
(51) Int. Cl.: H01L 25/16

(54) **LIGHT-EMITTING ELEMENT, DISPLAY SUBSTRATE, AND DISPLAY DEVICE**

(71) Applicant: Boe Technology Group Co., Ltd., Beijing 100015 (CN); Hefei Boe Ruisheng Technology Co., Ltd., Hefei, Anhui 230012 (CN)
(72) Inventor: SUN, Yiding, Beijing 100176 (CN); WANG, Kangli, Beijing 100176 (CN); KANG, Ping, Beijing 100176 (CN); CHENG, Amei, Beijing 100176 (CN); LV, Chaoren, Beijing 100176 (CN); GAO, Liang, Beijing 100176 (CN)
(74) Representative: Klunker IP Patentanwälte PartG mbB
(86) International application number: PCT/CN2022/141541
(87) International publication number: WO 2024/130724

(57) **Abstract**

A light-emitting element, a display substrate, and a display device. The light-emitting element comprises a substrate, a plurality of light-emitting structures, a leveling layer, a connecting electrode layer, an insulating layer, and a plurality of bonding pads. The plurality of light-emitting structures are located on the substrate. The leveling layer is located between the plurality of light-emitting structures. The connecting electrode layer is located on the side of the leveling layer away from the substrate. The insulating layer is located on the side of the connecting electrode layer away from the leveling layer. The plurality of bonding pads are located on the side of the insulating layer away from the connecting electrode layer. Each light-emitting structure comprises a first electrode and a second electrode. The connecting electrode layer comprises a plurality of connecting electrodes. Each connecting electrode is connected to the first electrode or the second electrode of at least one light-emitting structure. The light-emitting element further comprises a plurality of openings located in the insulating layer. The plurality of bonding pads are connected to the plurality of connecting electrodes by means of the plurality of openings. **In** this way, the light-emitting element can reduce or even prevent defects of missing parts and improve die bonding efficiency.

## Description

### TECHNICAL FIELD

Embodiments of the present disclosure relate to a light emitting element, a display substrate, and a display device.

### BACKGROUND

Micro light emitting structure (Micro LED) display technology is a display technology in which self-luminous micro light emitting structures are used as light emitting units and disposed in an array on a driving substrate. Since micro light emitting structures are directly used as light emitting units, the micro light emitting structure display technology has the advantages of high brightness, high resolution, high contrast, low energy consumption, rapid response, good thermal stability, etc.

Typically, a Mini light emitting diode (Mini LED) has a size of about 100 µm to 300 µm, and a Micro light emitting diode (Micro LED) has a size of less than 100 µm.

### SUMMARY

An embodiment of the present disclosure provides a light emitting element, a display substrate and a display device. The light emitting element includes: a base substrate; a plurality of light emitting structures located on the base substrate, a filling layer located among the plurality of light emitting structures; a connecting electrode layer located at a side, away from the base substrate, of the filling layer; an insulating layer located at a side, away from the filling layer, of the connecting electrode layer; and a plurality of pads located at a side, away from the connecting electrode layer, of the insulating layer; each of the plurality of light emitting structures includes a first pole and a second pole; the connecting electrode layer includes a plurality of connecting electrodes, and each of the plurality of connecting electrodes is connected to the first pole or the second pole of at least one light emitting structure; and the light emitting element further includes a plurality of holes located in the insulating layer, and the plurality of pads are connected to the plurality of connecting electrodes through the plurality of holes. In this way, a plurality of light emitting structures are packaged together for the light emitting element, and therefore, only one die bonding process is needed, and it is unnecessary to carry out a plurality of die bonding processes for the micro light emitting structures of different colors. On the one hand, the light emitting element can avoid the interference problem arising in a plurality of die bonding processes, thus improving and even avoiding the element missing defect. On the other hand, the light emitting element can also effectively reduce the die bonding time for a single display substrate and improve the die bonding efficiency. Moreover, a size of a single light emitting element is large enough so that repair for a defective pixel can be carried out through a vacuum adsorption hole.

At least one embodiment of the present disclosure provides a light emitting element including a base substrate; a plurality of light emitting structures located on the base substrate, a filling layer located among the plurality of light emitting structures; a connecting electrode layer located at a side, away from the base substrate, of the filling layer; an insulating layer located at a side, away from the filling layer, of the connecting electrode layer; and a plurality of pads located at a side, away from the connecting electrode layer, of the insulating layer; each of the plurality of light emitting structures includes a first pole and a second pole; the connecting electrode layer includes a plurality of connecting electrodes, and each of the plurality of connecting electrodes is connected to the first pole or the second pole of at least one light emitting structure; and the light emitting element further includes a plurality of holes located in the insulating layer, and the plurality of pads are connected to the plurality of connecting electrodes through the plurality of holes.

For example, in the light emitting element provided by an embodiment of the present disclosure, a number of the plurality of light emitting structures is N, and a value range of a number of the plurality of pads is from N+1 to 2N.

For example, in the light emitting element provided by an embodiment of the present disclosure, a height of each of the plurality of pads relative to the base substrate is greater than a height of the insulating layer relative to the base substrate.

For example, in the light emitting element provided by an embodiment of the present disclosure, the base substrate includes a sapphire substrate.

For example, in the light emitting element provided by an embodiment of the present disclosure, a distance between two adjacent light emitting structures is less than 100 microns.

For example, in the light emitting element provided by an embodiment of the present disclosure, an orthographic projection of the connecting electrode on the base substrate is larger than an orthographic projection of the pad connected to the connecting electrode on the base substrate.

For example, in the light emitting element provided by an embodiment of the present disclosure, the plurality of light emitting structures include a first light emitting structure, a second light emitting structure, and a third light emitting structure; the first light emitting structure is configured to emit light of a first color; the second light emitting structure is configured to emit light of a second color; and the third light emitting structure is configured to emit light of a third color.

For example, in the light emitting element provided by an embodiment of the present disclosure, the plurality of connecting electrodes include a first connecting electrode, a second connecting electrode, a third connecting electrode, a fourth connecting electrode, a fifth connecting electrode, and a sixth connecting electrode; the plurality of pads include a first pad, a second pad, a third pad, a fourth pad, a fifth pad, and a sixth pad; the first connecting electrode and the second connecting electrode connect the first pole and the second pole of the first light emitting structure to the first pad and the second pad, respectively; the third connecting electrode and the fourth connecting electrode connect the first pole and the second pole of the second light emitting structure to the third pad and the fourth pad, respectively; and the fifth connecting electrode and the sixth connecting electrode connect the first pole and the second pole of the third light emitting structure to the fifth pad and the sixth pad, respectively.

For example, in the light emitting element provided by an embodiment of the present disclosure, the first pad and the second pad are arranged along a first direction; the fifth pad and the sixth pad are arranged along the first direction; the first pad and the fifth pad are spaced apart oppositely in a second direction intersecting with the first direction; the second pad and the sixth pad are spaced apart oppositely in the second direction; the third pad is located at a side, away from the sixth pad, of the fifth pad; the fourth pad is located at a side, away from the second pad, of the first pad; the third pad and the fourth pad are spaced apart oppositely in the second direction; and the first light emitting structure, the second light emitting structure, and the third light emitting structure are located between a first connecting line of a center of the second pad and a center of the sixth pad and a second connecting line of a center of the third pad and a center of the fourth pad.

For example, in the light emitting element provided by an embodiment of the present disclosure, a first gap is provided between the first pad and the fifth pad; a second gap is provided between the second pad and the sixth pad; a third gap is provided between the third pad and the fourth pad; and the first light emitting structure, the second light emitting structure, and the third light emitting structure are located in a region between the second gap and the third gap.

For example, in the light emitting element provided by an embodiment of the present disclosure, an area of the first pad is smaller than an area of the second pad; an area of the fifth pad is smaller than an area of the sixth pad; and the first light emitting structure and the third light emitting structure are located between the first pad and the fifth pad.

For example, in the light emitting element provided by an embodiment of the present disclosure, the second light emitting structure is located between a third connecting line of a center of the first light emitting structure and the center of the third light emitting structure and the second connecting line.

For example, in the light emitting element provided by an embodiment of the present disclosure, connecting lines of a center of the first light emitting structure, a center of the second light emitting structure, and a center of the third light emitting structure form a triangle.

For example, in the light emitting element provided by an embodiment of the present disclosure, the first pad, the third pad, and the fifth pad are arranged along a first direction; the second pad, the fourth pad, and the sixth pad are arranged along the first direction; the first pad and the second pad are spaced apart oppositely in a second direction intersecting with the first direction; the third pad and the fourth pad are spaced apart oppositely in the second direction; the fifth pad and the sixth pad are spaced apart oppositely in the second direction; the first light emitting structure is located between the first pad and the second pad; the second light emitting structure is located between the third pad and the fourth pad; and the third light emitting structure is located between the fifth pad and the sixth pad.

For example, in the light emitting element provided by an embodiment of the present disclosure, orthographic projections of the first pad, the second pad, the third pad, the fourth pad, the fifth pad, and the sixth pad on the base substrate are approximately the same in size.

For example, in the light emitting element provided by an embodiment of the present disclosure, the first pad is connected to the first pole of the first light emitting structure; the third pad is connected to the first pole of the second light emitting structure; the fifth pad is connected to the first pole of the third light emitting structure; the second pad is connected to the second pole of the first light emitting structure; the fourth pad is connected to the second pole of the second light emitting structure; and the sixth pad is connected to the second pole of the third light emitting structure.

For example, in the light emitting element provided by an embodiment of the present disclosure, a size of the light emitting element in the first direction is less than or equal to 500 microns.

For example, in the light emitting element provided by an embodiment of the present disclosure, the plurality of connecting electrodes include a first connecting electrode, a second connecting electrode, a third connecting electrode, a fourth connecting electrode, a fifth connecting electrode, and a sixth connecting electrode; the plurality of pads include a first pad, a second pad, a third pad, a fourth pad, and a fifth pad; the first connecting electrode and the second connecting electrode connect the first pole and the second pole of the first light emitting structure to the first pad and the second pad, respectively; the third connecting electrode and the fourth connecting electrode connect the first pole and the second pole of the second light emitting structure to the third pad and the fourth pad, respectively; and the fifth connecting electrode and the sixth connecting electrode connect the first pole and the second pole of the third light emitting structure to the third pad and the fifth pad, respectively.

For example, in the light emitting element provided by an embodiment of the present disclosure, the first pad and the second pad are arranged along a first direction and spaced apart oppositely; the fourth pad and the fifth pad are arranged along the first direction and spaced apart oppositely; the fourth pad and the first pad are spaced apart oppositely in a second direction intersecting with the first direction; the third pad is disposed in a region defined by the first pad, the second pad, the fourth pad, and the fifth pad; the first light emitting structure is located between the first pad and the second pad; the second light emitting structure is located between the first pad and the fourth pad; and the third light emitting structure is located between the fourth pad and the fifth pad.

For example, in the light emitting element provided by an embodiment of the present disclosure, the first light emitting structure and the third light emitting structure are located at two sides of the third pad in the second direction, respectively.

For example, in the light emitting element provided by an embodiment of the present disclosure, a size of the light emitting element in the first direction is less than or equal to 250 microns.

For example, in the light emitting element provided by an embodiment of the present disclosure, the first pad and the second pad are arranged along a first direction and spaced apart oppositely; the third pad and the fifth pad are arranged along the first direction and spaced apart oppositely; the third pad and the first pad are spaced apart oppositely in a second direction intersecting with the first direction; the fourth pad is disposed in a region defined by the first pad, the second pad, the third pad, and the fifth pad; the first light emitting structure is located between the first pad and the second pad; the second light emitting structure is located between the first pad and the third pad; and the third light emitting structure is located between the third pad and the fifth pad.

For example, in the light emitting element provided by an embodiment of the present disclosure, the first color is green color; the second color is red color; and the third color is blue color.

At least one embodiment of the present disclosure further provides a display substrate, including: a driving substrate; and a plurality of light emitting elements arranged in an array on the driving substrate, the plurality of light emitting elements include the light emitting element described in any of the above.

For example, in the display substrate provided by an embodiment of the present disclosure, it further includes a plurality of micro driving chips disposed corresponding to the plurality of light emitting elements, and each of the plurality of micro driving chips is configured to drive the corresponding light emitting element to emit light for displaying.

For example, in the display substrate provided by an embodiment of the present disclosure, the driving substrate includes a ground line; and an orthographic projection of the light emitting element on the driving substrate overlaps with the ground line.

For example, in the display substrate provided by an embodiment of the present disclosure, the driving substrate includes a first signal line, a second signal line, a working voltage line, and a data line; each of the plurality of micro driving chips includes a data signal terminal, a working voltage terminal, a ground terminal, a first output terminal, a second output terminal, and a third output terminal; the data signal terminal is connected to the data line through a first connection line; the working voltage terminal is connected to the working voltage line through a second connection line; the ground terminal is connected to the ground line through a third connection line; the first output terminal is connected to the second pole of the first light emitting structure; the second output terminal is connected to the second pole of the second light emitting structure; the third output terminal is connected to the second pole of the third light emitting structure; the first signal line is connected to the first pole of the first light emitting structure through a fourth connection line; the second signal line is connected to the first pole of the second light emitting structure through a fifth connection line; and the second signal line is connected to the first pole of the third light emitting structure through a sixth connection line.

At least one embodiment of the present disclosure further provides a display device, including the display substrate described in any of the above.

### BRIEF DESCRIPTION OF DRAWINGS

In order to more clearly illustrate the technical solutions of the embodiments of the present disclosure, the drawings of the embodiments will be briefly described in the following; it is obvious that the described drawings are only related to some embodiments of the present disclosure and thus are not limitative to the present disclosure.
FIG. 1 is a schematic diagram of a driving mode for a single pixel in a display substrate.
FIG. 2A to FIG. 2C illustrate an element missing defect of a display substrate.
FIG. 3 illustrates an interference phenomenon of a display substrate in a die bonding process.
FIG. 4 is a schematic plan view of a light emitting element provided by an embodiment of the present disclosure.
FIG. 5 is a schematic cross-sectional view, along a direction AB in FIG. 4, of a light emitting element provided by an embodiment of the present disclosure.
FIG. 6 is a schematic plan view of another light emitting element provided by an embodiment of the present disclosure.
FIG. 7 is a schematic plan view of another light emitting element provided by an embodiment of the present disclosure.
FIG. 8 is a schematic plan view of another light emitting element provided by an embodiment of the present disclosure.
FIG. 9 is a schematic plan view of a display substrate provided by an embodiment of the present disclosure.
FIG. 10 is a schematic diagram of a part of a display substrate provided by an embodiment of the present disclosure.
FIG. 11 is a schematic diagram of a part of another display substrate provided by an embodiment of the present disclosure.
FIG. 12 is a schematic diagram of a part of another display substrate provided by an embodiment of the present disclosure.
FIG. 13 is a schematic diagram of a part of another display substrate provided by an embodiment of the present disclosure.
FIG. 14 is a schematic diagram of a display device provided by an embodiment of the present disclosure.

### DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the present disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly.

Unless otherwise defined, features such as "parallel", "perpendicular", and "identical" used in the embodiments of the present disclosure include cases such as "parallel", "perpendicular", and "identical" in the strict sense, and cases such as "substantially parallel", "substantially perpendicular", and "substantially identical" including a certain error. For example, the above-mentioned "substantially" may represent that a difference between objects as compared is 10% or within 5% of an average value of the objects as compared. When the number of components or elements is not specified in the context of the embodiments of the present disclosure, it means that there may be one or more components or elements, and it may be construed as there may be at least one component or element. "At least one" refers to one or more, and "a plurality of" refers to at least two.

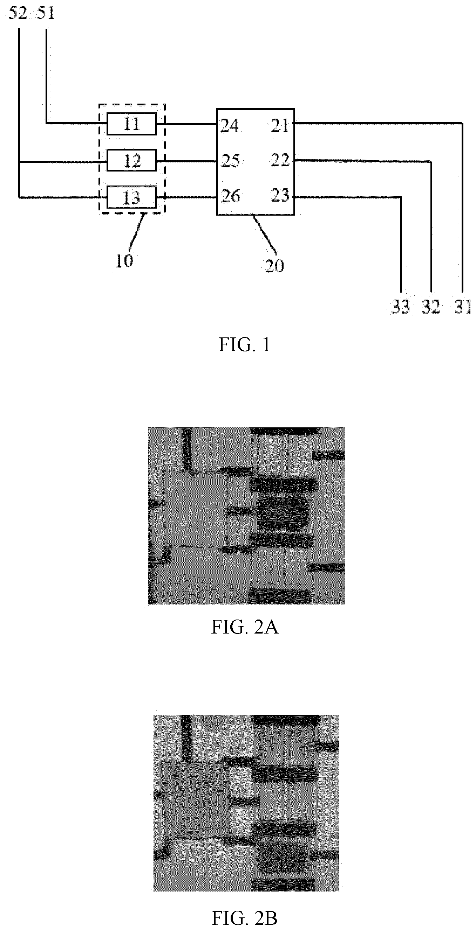

FIG. 1 is a schematic diagram of a driving mode for a single pixel in a display substrate. As shown in FIG. 1, a single pixel 10 in the display substrate may be composed of three micro light emitting structures. These three micro light emitting structures may include a red micro light emitting structure 11 (R-LED), a green micro light emitting structure 12 (G-LED), and a blue micro light emitting structure 13 (B-LED). The single pixel 10 may be controlled by a micro driving chip 20 that includes three input terminals and three output terminals. The three input terminals include a data terminal 21, a working voltage terminal 22, and a ground terminal 23. The data terminal 21 may be connected to a data line 21. The working voltage terminal 22 may be connected to a working voltage line 32. The ground terminal 23 may be connected to a ground line 33. The three output terminals include a first output terminal 24, a second output terminal 25, and a third output terminal 26. The first output terminal 24 may provide a low voltage for the red micro light emitting structure 11. The second output terminal 25 may provide a low voltage for the green micro light emitting structure 12. The third output terminal 26 may provide a low voltage for the blue micro light emitting structure 13. Each micro light emitting structure may include two pins, one of which may be connected to one of the three output terminals and the other one of which may be connected to a signal line that provides a high voltage. For example, the red micro light emitting structure 11 is connected to a first signal line 51, and the green micro light emitting structure 12 and the blue micro light emitting structure 13 are connected to a second signal line 52. Thus, the micro driving chip may control the brightness of the red micro light emitting structure (R-LED), the green micro light emitting structure (G-LED), and the blue micro light emitting structure (B-LED) by controlling voltage signals of the three output terminals, thereby realizing the display function.

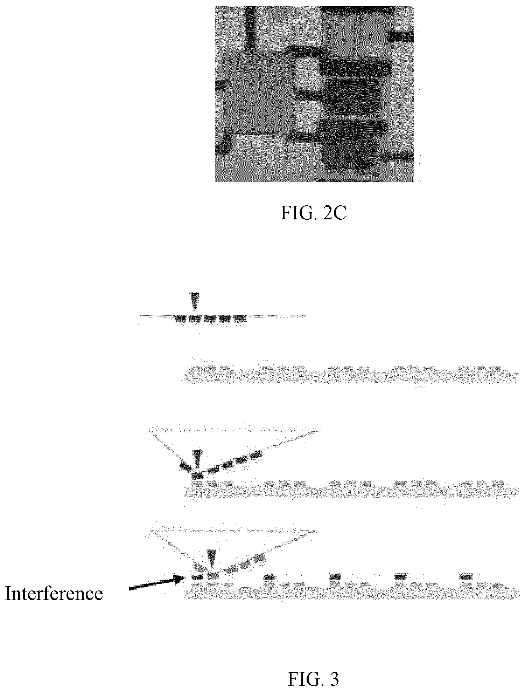

However, due to the requirement on a display effect, a size of a single micro light emitting structure is set to about 150*90 µm, and a gap between micro light emitting structures within the single pixel is about 100 µm (because a minimum size of an RW vacuum adsorption hole is 100 µm). Such a size is prone to cause the element missing defect in a piercing die bonding process, and cases of such defect are shown in FIG. 2A to FIG. 2C. As shown in FIG. 2A to FIG. 2C, these three pixels all involve issues in which some micro light emitting structures are missing.

Upon study, as shown in FIG. 3, the element missing defect is mainly because of an interference phenomenon occurred in the die bonding process due to a too small gap between micro light emitting structures. For example, three types of micro light emitting structures are bonded in sequence, where red micro light emitting structures are bonded firstly. Subsequently, in the process of bonding the green micro light emitting structures and the blue micro light emitting structures, an interference occurs between a micro light emitting structure chip on a wafer and a red micro light emitting structure on a driving substrate, and the micro light emitting structure chip on the driving substrate is brought away, leading to the element missing defect.

On the other hand, due to a large number of (e.g., more than 500,000) micro light emitting structures in a single display substrate, the die bonding time for the single display substrate exceeds 16h and thus becomes a bottleneck which limits the production capacity. Moreover, since the micro light emitting structure chip has a small size such as 150*90 microns and the minimum diameter of a vacuum adsorption hole is 100 microns, the repair for a defective pixel cannot be realized.

In conclusion, how to overcome the element missing defect, how to improve the die bonding efficiency, and how to realize repair for a defective pixel are key problems to improve the yield of products and the production capability.

In view of this, the embodiments of the present disclosure provide a light emitting element, a display substrate, and a display device. The light emitting element includes a base substrate, a plurality of light emitting structures, a filling layer, a connecting electrode layer, an insulating layer, and a plurality of pads. The plurality of light emitting structures are located on the base substrate. The filling layer is located among the plurality of light emitting structures. The connecting electrode layer is located at a side, away from the base substrate, of the filling layer. The insulating layer is located at a side, away from the filling layer, of the connecting electrode layer. The plurality of pads are located at a side, away from the connecting electrode layer, of the insulating layer. Each light emitting structure includes a first pole and a second pole. The connecting electrode layer includes a plurality of connecting electrodes, and each connecting electrode is connected to the first pole or the second pole of at least one light emitting structure. The light emitting element further includes a plurality of holes in the insulating layer. The plurality of pads are connected to the plurality of connecting electrodes through the plurality of holes. Thus, a plurality of light emitting structures are packaged together for the light emitting element, and therefore, only one die bonding process is needed, and it is unnecessary to carry out a plurality of die bonding processes for the micro light emitting structures of different colors. On the one hand, the light emitting element can avoid the interference problem arising in a plurality of die bonding processes, thus improving and even avoiding the element missing defect. On the other hand, the light emitting element can also effectively reduce the die bonding time for a single display substrate and improve the die bonding efficiency. Moreover, a size of a single light emitting element is large enough so that a repair for a defective pixel can be carried out through a vacuum adsorption hole.

The light emitting element, the display substrate, and the display device provided by the embodiments of the present disclosure will be described in detail below with reference to the accompanying drawings.

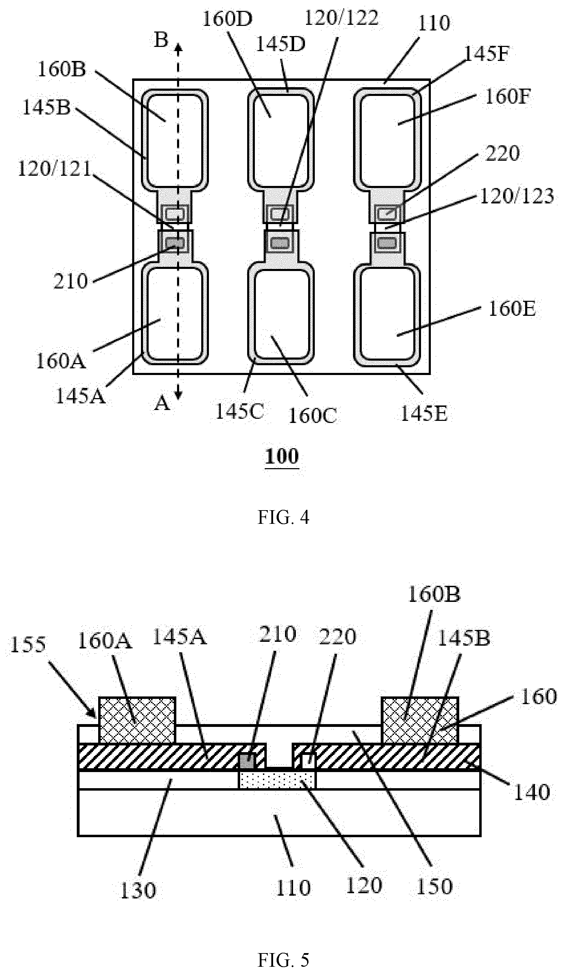

An embodiment of the present disclosure provides a light emitting element. FIG. 4 is a schematic plan view of a light emitting element provided by an embodiment of the present disclosure, and FIG. 5 is a schematic cross-sectional view, along a direction AB in FIG. 4, of a light emitting element provided by an embodiment of the present disclosure.

As shown in FIG. 4 and FIG. 5, the light emitting element 100 includes a base substrate 110, a plurality of light emitting structures 120, a filling layer 130, a connecting electrode layer 140, an insulating layer 150, and a plurality of pads 160. The plurality of light emitting structures 120 are located on the base substrate 110. The filling layer 130 is located among the plurality of light emitting structures 120. The connecting electrode layer 140 is located at a side, away from the base substrate 110, of the filling layer 130. The insulating layer 150 is located at a side, away from the filling layer 130, of the connecting electrode layer 140. The plurality of pads 160 are located at a side, away from the connecting electrode layer 140, of the insulating layer 150. Each light emitting structure 120 includes a first pole 210 and a second pole 220. The connecting electrode layer 140 includes a plurality of connecting electrodes 145, and each connecting electrode 145 is connected to the first pole 210 or the second pole 220 of at least one light emitting structure 120. The light emitting element 100 further includes a plurality of holes 155 in the insulating layer 150. The plurality of pads 160 are connected to the plurality of connecting electrodes 145 through the plurality of holes 155. It needs to be noted that the "light emitting structure" herein generally refers to the micro light emitting structure. Moreover, the "light emitting structure" herein is unpackaged and includes only a PN junction, a light emitting layer, and other functional layer(s) assisting in light emission, and is not a usual single light emitting diode.

In the light emitting element provided by the embodiment of the present disclosure, the plurality of light emitting structures are located on the base substrate and packaged together with the filling layer, the connecting electrode layer, the insulating layer, and the plurality of pads. Therefore, when applied to a display substrate, the light emitting element can be assembled on the driving substrate as a whole by only one die bonding process, and it is unnecessary to carry out a plurality of die bonding processes for micro light emitting structures of different colors. In this case, on the one hand, the light emitting element can avoid the interference problem arising in a plurality of die bonding processes, thus improving and even avoiding the element missing defect. On the other hand, the light emitting element includes a plurality of light emitting structures, which allows for a reduction in times of transfer as needed, and thus can also effectively reduce the die bonding time for a single display substrate and improve the die bonding efficiency. Moreover, the size of a single light emitting element is large enough so that a repair for a defective pixel can be carried out through a vacuum adsorption hole. In some examples, as shown in FIG. 4 and FIG. 5, three light emitting structures 120 are located on the base substrate 110. The connecting electrode layer 140 includes six connecting electrodes 145. The six connecting electrodes 145 are connected to three first poles 210 and three second poles 220 of the three light emitting structures 120, respectively, and then connected to sixth pads 160 through six holes 155. Thus, electrical signals may be applied to the three first poles and the three second poles of the three light emitting structures through the six pads, respectively. It needs to be noted that, in the embodiment, one connecting electrode is merely connected to one electrode of one light emitting structure. However, the present disclosure includes but is not limited thereto. In some cases, one connecting electrode may be connected to the electrodes of a plurality of light emitting structures, so that the plurality of light emitting structures share one electrical signal.

In some examples, when the number of the light emitting structures 120 is N, a value range of the number of the plurality of pads 160 is from N+1 to 2N. In other words, the electrodes of at least two light emitting structures of the plurality of light emitting structures may share one pad.

In some examples, as shown in FIG. 4, an orthographic projection of the connecting electrode 145 on the base substrate 110 is larger than an orthographic projection of a pad 160 connected to the connecting electrode 145 on the base substrate 110, thus guaranteeing the reliability and durability of electrical connection therebetween. In some examples, as shown in FIG. 4 and FIG. 5, a height of each pad 160 relative to the base substrate 110 is greater than a height of the insulating layer 150 relative to the base substrate 110. For example, in a direction perpendicular to the base substrate 110, a thickness of the pad 160 may also be greater than that of the insulating layer 150.

In some examples, as shown in FIG. 4 and FIG. 5, the base substrate 110 may be a sapphire substrate. As a matter of course, the present disclosure includes but is not limited thereto.

In some examples, as shown in FIG. 4 and FIG. 5, a distance between two adjacent light emitting structures 120 is less than 100 microns. Thus, the light emitting element may further have an improved level of integration and thus may increase the resolution of a display substrate using the light emitting structure package.

In some examples, as shown in FIG. 4 and FIG. 5, a plurality of light emitting structures 120 included in a single light emitting element 100 include light emitting structures 120 emitting light of different colors.

In some examples, as shown in FIG. 4 and FIG. 5, the plurality of light emitting structures 120 include a first light emitting structure 121, a second light emitting structure 122, and a third light emitting structure 123. The first light emitting structure 121 is configured to emit light of a first color; the second light emitting structure 122 is configured to emit light of a second color; and the third light emitting structure 123 is configured to emit light of a third color. It needs to be noted that, the first color, the second color, and the third color are different.

In some examples, the first color is red; the second color is green; and the third color is blue. As a matter of course, the present disclosure includes but is not limited thereto. The first color, the second color, and the third color may also be other colors.

In some examples, as shown in FIG. 4, the plurality of connecting electrodes 145 include a first connecting electrode 145A, a second connecting electrode 145B, a third connecting electrode 145C, a fourth connecting electrode 145D, a fifth connecting electrode 145E, and a sixth connecting electrode 145F. The plurality of pads 160 include a first pad 160A, a second pad 160B, a third pad 160C, a fourth pad 160D, a fifth pad 160E, and a sixth pad 160F. The first connecting electrode 145A and the second connecting electrode 145B connect the first pole 210 and the second pole 220 of the first light emitting structure 121 to the first pad 160A and the second pad 160B, respectively. The third connecting electrode 145C and the fourth connecting electrode 145D connect the first pole 210 and the second pole 220 of the second light emitting structure 122 to the third pad 160C and the fourth pad 160D, respectively. The fifth connecting electrode 145E and the sixth connecting electrode 145F connect the first pole 210 and the second pole 220 of the third light emitting structure 123 to the fifth pad 160E and the sixth pad 160F, respectively.

In some examples, as shown in FIG. 4, the first pad 160A, the third pad 160C, and the fifth pad 160E are arranged in a first direction. The second pad 160B, the fourth pad 160D, and the sixth pad 160F are arranged in the first direction. The first pad 160A and the second pad 160B are spaced apart oppositely in a second direction intersecting with the first direction. The third pad 160C and the fourth pad 160D are spaced apart oppositely in the second direction. The fifth pad 160E and the sixth pad 160F are spaced apart oppositely in the second direction. The first light emitting structure 121 is located between the first pad 160A and the second pad 160B. The second light emitting structure 122 is located between the third pad 160C and the fourth pad 160D. The third light emitting structure 123 is located between the fifth pad 160E and the sixth pad 160F.

In some examples, as shown in FIG. 4, orthographic projections of the first pad 160A, the second pad 160B, the third pad 160C, the fourth pad 160D, the fifth pad 160E, and the sixth pad 160F on the base substrate 110 are approximately the same in size. For example, a difference between areas of the orthographic projections of the first pad 160A, the second pad 160B, the third pad 160C, the fourth pad 160D, the fifth pad 160E, and the sixth pad 160F on the base substrate 110 is less than 10% of an average value of the areas of their orthographic projections on the base substrate 110.

In some examples, as shown in FIG. 4, the first pad 160A is connected to the first pole of the first light emitting structure 121. The third pad 160C is connected to the first pole of the second light emitting structure 122. The fifth pad 160E is connected to the first pole of the third light emitting structure 123. The second pad 160B is connected to the second pole of the first light emitting structure 121. The fourth pad 160D is connected to the second pole of the second light emitting structure 122. The sixth pad 160F is connected to the second pole of the third light emitting structure 123.

In some examples, as shown in FIG. 4, a size of the light emitting element 100 in the first direction is less than or equal to 500 microns, e.g., 400 microns. Generally, three light emitting structures have a size of 150*90 microns, and a gap between adjacent light emitting structures is about 100 microns; as a result, the size occupied by the three light emitting structures usually is 570 microns. However, the size of the light emitting element provided by the embodiment of the present disclosure in the first direction is less than or equal to 500 microns. Therefore, the light emitting element improves the level of integration of a plurality of light emitting structures.

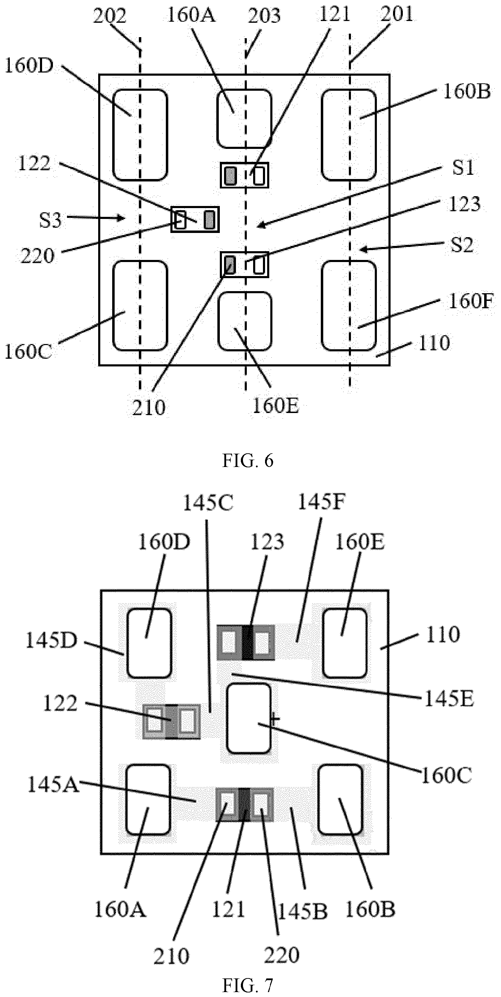

FIG. 6 is a schematic plan view of another light emitting element provided by an embodiment of the present disclosure. Unlike the light emitting element shown in FIG. 4, as shown in FIG. 6, the first pad 160A and the second pad 160B are arranged in the first direction. The fifth pad 160E and the sixth pad 160F are arranged in the first direction. The first pad 160A and the fifth pad 160E are spaced apart oppositely in the second direction intersecting with the first direction. The second pad 160B and the sixth pad 160F are spaced apart oppositely in the second direction. The third pad 160C is located at a side, away from the sixth pad 160F, of the fifth pad 160E. The fourth pad 160D is located at a side, away from the second pad 160B, of the first pad 160A. The third pad 160C and the fourth pad 160D are spaced apart oppositely in the second direction. The first light emitting structure 121, the second light emitting structure 122, and the third light emitting structure 123 are located between a first connecting line 201 of a center of the second pad 160B and a center of the sixth pad 160F and a second connecting line 202 of a center of the third pad 160C and a center of the fourth pad 160D. Thus, the light emitting element can avoid direct contact between an ejector needle and the light emitting structure in the die bonding process and thus can prevent the ejector needle from damaging the light emitting structure, thereby improving the yield of products.

For example, the second direction and the first direction may be perpendicular to each other. As a matter of course, the present disclosure includes but is not limited thereto.

In some examples, as shown in FIG. 6, a first gap S1 is formed between the first pad 160A and the fifth pad 160E. A second gap S2 is formed between the second pad 160B and the sixth pad 160F. A third gap S3 is formed between the third pad 160C and the fourth pad 160D. The first light emitting structure 121, the second light emitting structure 122, and the third light emitting structure 123 are located in a region between the second gap S2 and the third gap S3. Thus, the light emitting element can well prevent the ejector needle from damaging the light emitting structure in the die bonding process.

In some examples, as shown in FIG. 6, an area of the first pad 160A is smaller than an area of the second pad 160B, and an area of the fifth pad 160E is smaller than an area of the sixth pad 160F, which provides a large space between the first pad 160A and the fifth pad 160E. At this time, the first light emitting structure 121 and the third light emitting structure 123 are located between the first pad 160A and the fifth pad 160E. Thus, the light emitting element can well prevent the ejector needle from damaging the light emitting structure in the die bonding process.

In some examples, as shown in FIG. 6, the second light emitting structure 122 is located between a third connecting line 203 of a center of the first light emitting structure 121 and a center of the third light emitting structure 123 and the second connecting line 202. Thus, the light emitting element can well prevent the ejector needle from damaging the light emitting structure in the die bonding process.

In some examples, as shown in FIG. 6, connecting lines of the center of the first light emitting structure 121, the center of the second light emitting structure 122, and the center of the third light emitting structure 123 form a triangle.

In some examples, as shown in FIG. 6, the size of the light emitting element 100 in the first direction is less than or equal to 500 microns, e.g., 400 microns. Generally, three light emitting structures have a size of 150*90 microns, and a gap between adjacent light emitting structures is about 100 microns; as a result, the size occupied by the three light emitting structures usually is 570 microns. However, the size of the light emitting element provided by the embodiment of the present disclosure in the first direction is less than or equal to 500 microns. Therefore, the light emitting element improves the level of integration.

FIG. 7 is a schematic plan view of another light emitting element provided by an embodiment of the present disclosure. As shown in FIG. 7, the plurality of connecting electrodes 145 include a first connecting electrode 145A, a second connecting electrode 145B, a third connecting electrode 145C, a fourth connecting electrode 145D, a fifth connecting electrode 145E, and a sixth connecting electrode 145F. The plurality of pads 160 include a first pad 160A, a second pad 160B, a third pad 160C, a fourth pad 160D, and a fifth pad 160E. The first connecting electrode 145A and the second connecting electrode 145B connect the first pole 210 and the second pole 220 of the first light emitting structure 121 to the first pad 160A and the second pad 160B, respectively. The third connecting electrode 145C and the fourth connecting electrode 145D connect the first pole 210 and the second pole 220 of the second light emitting structure 122 to the third pad 160C and the fourth pad 160D, respectively. The fifth connecting electrode 145E and the sixth connecting electrode 145F connect the first pole 210 and the second pole 220 of the third light emitting structure 123 to the fifth pad 160E and the sixth pad 160F, respectively. Thus, the first pole 210 of the second light emitting structure 122 and the first pole 210 of the third light emitting structure 123 share the third pad 160C so that the level of integration of the light emitting element can be further improved, thereby reducing the size of the light emitting element.

In some examples, as shown in FIG. 7, the third connecting electrode 145C and the fifth connecting electrode 145E may be integrated.

It needs to be noted that a same voltage may be applied to an anode of a green light emitting diode and an anode of a blue light emitting diode, and a different voltage may be applied to an anode of a red light emitting diode. Therefore, they may share a same pad; at this time, the two connecting electrodes connected to this pad may also be integrated.

In some examples, the size of the light emitting element in the first direction is less than or equal to 250 microns, e.g., 200 microns. Generally, three light emitting structures have a size of 150*90 microns, and a gap between adjacent light emitting structures is about 100 microns; as a result, the size occupied by the three light emitting structures usually is 570 microns. However, the size of the light emitting element provided by the embodiment of the present disclosure in the first direction is less than or equal to 250 microns. Therefore, the light emitting element has a greatly improved level of integration and a reduced size.

In some examples, as shown in FIG. 7, the first pad 160A and the second pad 160B are arranged in the first direction and spaced apart oppositely. The fourth pad 160D and the fifth pad 160E are arranged in the first direction and spaced apart oppositely. The fourth pad 160D and the first pad 160A are spaced apart oppositely in the second direction intersecting with the first direction. The third pad 160C is disposed in a region defined by the first pad 160A, the second pad 160B, the fourth pad 160D, and the fifth pad 160E. The first light emitting structure 121 is located between the first pad 160A and the second pad 160B. The second light emitting structure 122 is located between the first pad 160A and the fourth pad 160D. The third light emitting structure 123 is located between the fourth pad 160D and the fifth pad 160E. Thus, the light emitting element can avoid direct contact between an ejector needle and the light emitting structure in the die bonding process and thus can prevent the ejector needle from damaging the light emitting structure, thereby improving the yield of products.

In some examples, as shown in FIG. 7, the first light emitting structure 121 and the third light emitting structure 123 are located at two sides of the third pad 160C in the second direction, respectively.

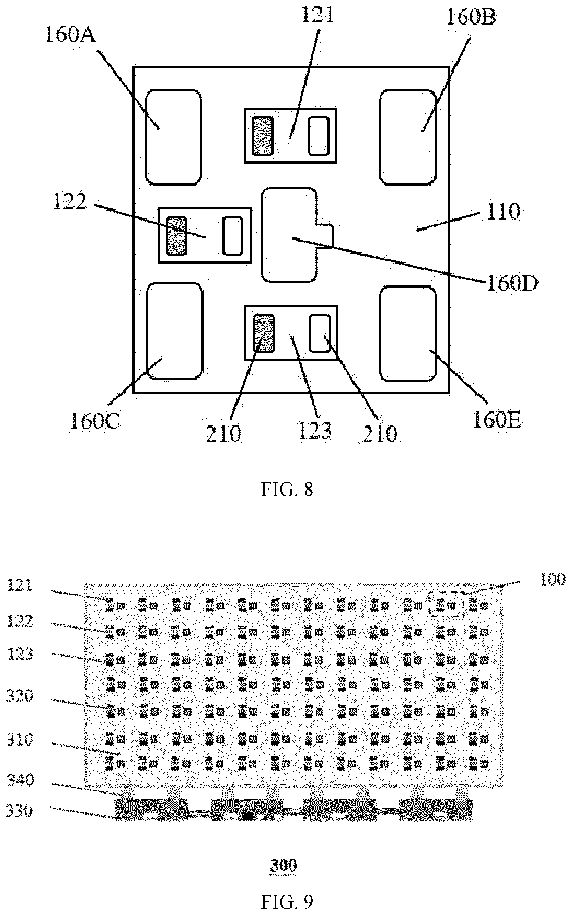

FIG. 8 is a schematic plan view of another light emitting element provided by an embodiment of the present disclosure. As shown in FIG. 8, unlike FIG. 7, the first pad 160A and the second pad 160B are arranged in the first direction and spaced apart oppositely. The third pad 160C and the fifth pad 160E are arranged in the first direction and spaced apart oppositely. The third pad 160C and the first pad 160A are spaced apart oppositely in the second direction intersecting with the first direction. The fourth pad 160D is disposed in a region defined by the first pad 160A, the second pad 160B, the third pad 160C, and the fifth pad 160E. The first light emitting structure 121 is located between the first pad 160A and the second pad 160B. The second light emitting structure 122 is located between the first pad 160A and the third pad 160C. The third light emitting structure 123 is located between the third pad 160C and the fifth pad 160E. Thus, the light emitting element can avoid direct contact between an ejector needle and the light emitting structure in the die bonding process and thus can prevent the ejector needle from damaging the light emitting structure, thereby improving the yield of products. Moreover, the light emitting element is also convenient for routing and reducing the area of the connection lines, thereby improving the light transmittance.

An embodiment of the present disclosure further provides a display substrate. FIG. 9 is a schematic plan view of a display substrate provided by an embodiment of the present disclosure. As shown in FIG. 9, the display substrate 300 includes a driving substrate 310 and a plurality of light emitting elements 100 disposed in an array on the driving substrate 310. The plurality of light emitting elements 100 include the light emitting element 100 provided by any of the above examples.

In the display substrate provided by the embodiment of the present disclosure, since the plurality of light emitting structures in each light emitting element are located on the base substrate and packaged together with the filling layer, the connecting electrode layer, the insulating layer, and the plurality of pads, the display substrate can be assembled on the driving substrate as a whole by only one die bonding process, and it is unnecessary to carry out a plurality of die bonding processes for the micro light emitting structures of different colors. In this case, on the one hand, the display substrate can avoid the interference problem arising in a plurality of die bonding processes, thus improving and even avoiding the element missing defect. On the other hand, the display substrate includes a plurality of light emitting structures, allowing for a reduction in times of transfer as needed, and thus can also effectively reduce the die bonding time for a single display substrate and improve the die bonding efficiency. Moreover, the size of a single light emitting element is large enough so that a repair for a defective pixel can be carried out through a vacuum adsorption hole. It needs to be noted that since the light emitting element provided by some examples described above has a small size, the display substrate may further have an increased pixel density or resolution.

In conclusion, the display substrate can improve and even avoid the element missing defect and improve the die bonding efficiency, and can realize the repair of a defective pixel. Therefore, the display substrate can effectively improve the yield of products and the production capability.

In some examples, as shown in FIG. 9, the display substrate 300 further includes a plurality of micro driving chips 320. The plurality of micro driving chips 320 are disposed corresponding to the plurality of light emitting elements 100. Each micro driving chip 320 is configured to drive the corresponding light emitting element 100 to emit light for displaying.

In some examples, as shown in FIG. 9, the display substrate 300 may further include a driving circuit board 330 and a chip on film 340. The driving circuit board 330 is connected to the driving substrate 310 through the chip on film 340.

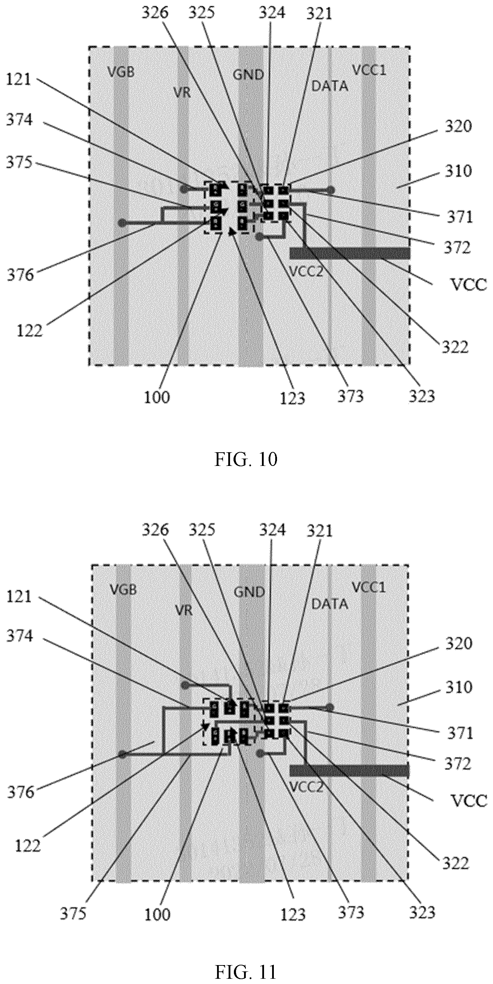

FIG. 10 is a schematic diagram of a part of a display substrate provided by an embodiment of the present disclosure. As shown in FIG. 10, the driving substrate 310 includes a ground line GND. An orthographic projection of the light emitting element 100 on the driving substrate 510 overlaps with the ground line GND. Thus, the signal crosstalk can be avoided and the display quality can be improved. It needs to be noted that the display substrate uses the light emitting element shown in FIG. 6.

In some examples, as shown in FIG. 10, an orthographic projection of the micro driving chip 320 on the driving substrate 510 also overlaps with the ground line GND.

In some examples, as shown in FIG. 10, the driving substrate 310 includes a first signal line VR, a second signal line VGB, a working voltage line VCC, and a data line DATA. Each micro driving chip 320 includes a working voltage terminal 322, a ground terminal 323, a data signal terminal 321, a first output terminal 324, a second output terminal 325, and a third output terminal 326. The data signal terminal 321 is connected to the data line DATA through a first connection line 371. The working voltage terminal 322 is connected to the working voltage line VCC through a second connection line 372. The ground terminal 323 is connected to the ground line GND through a third connection line 373.

In some examples, as shown in FIG. 10, the orthographic projection of the light emitting element 100 on the driving substrate 510 overlaps with a gap between the ground line GND and the first signal line VR. Thus, the signal crosstalk can be avoided and the display quality can be improved.

In some examples, as shown in FIG. 10, the orthographic projection of the micro driving chip 320 on the driving substrate 510 also overlaps with a gap between the ground line GND and the data line DATA.

In some examples, as shown in FIG. 10, the first output terminal 324 is connected to the second pole of the first light emitting structure 121 (by means of the pad and the connecting electrode described above). The second output terminal 325 is connected to the second pole of the second light emitting structure 122. The third output terminal 326 is connected to the second pole of the third light emitting structure 123. The first signal line VR is connected to the first pole of the first light emitting structure 121 through a fourth connection line 374. The second signal line VGB is connected to the first pole of the second light emitting structure 122 through a fifth connection line 375. The second signal line VGB is connected to the first pole of the third light emitting structure 123 through a sixth connection line 376.

In some examples, as shown in FIG. 10, the working voltage line VCC includes a first working voltage line VCC1 and a second working voltage line VCC2. The first working voltage line VCC1, the first signal line VR, the second signal line VGB, the ground line GND, and the data line DATA extend in a third direction. The second working voltage line VCC2 extends in a fourth direction intersecting with the third direction.

In some examples, as shown in FIG. 10, the fifth connection line 375 and the sixth connection line 376 intersect and are then connected to the second signal line VGB, so that the materials can be saved.

FIG. 11 is a schematic diagram of a part of another display substrate provided by an embodiment of the present disclosure. As shown in FIG. 11, unlike FIG. 10, the display substrate uses the light emitting element shown in FIG. 5.

In some examples, as shown in FIG. 11, the driving substrate 310 includes the first signal line VR, the second signal line VGB, the working voltage line VCC, and the data line DATA. Each micro driving chip 320 includes the working voltage terminal 322, the ground terminal 323, the data signal terminal 321, the first output terminal 324, the second output terminal 325, and the third output terminal 326. The data signal terminal 321 is connected to the data line DATA through the first connection line 371. The working voltage terminal 322 is connected to the working voltage line VCC through the second connection line 372. The ground terminal 323 is connected to the ground line GND through the third connection line 373.

In some examples, as shown in FIG. 11, the orthographic projection of the light emitting element 100 on the driving substrate 510 overlaps with the gap between the ground line GND and the first signal line VR. Thus, the signal crosstalk can be avoided and the display quality can be improved.

In some examples, as shown in FIG. 11, the orthographic projection of the micro driving chip 320 on the driving substrate 510 also overlaps with the gap between the ground line GND and the data line DATA.

In some examples, as shown in FIG. 11, the first output terminal 324 is connected to the second pole of the first light emitting structure 121 (by means of the pad and the connecting electrode described above). The second output terminal 325 is connected to the second pole of the second light emitting structure 122. The third output terminal 326 is connected to the second pole of the third light emitting structure 123. The first signal line VR is connected to the first pole of the first light emitting structure 121 through the fourth connection line 374. The second signal line VGB is connected to the first pole of the second light emitting structure 122 through the fifth connection line 375. The second signal line VGB is connected to the first pole of the third light emitting structure 123 through the sixth connection line 376.

In some examples, as shown in FIG. 11, the working voltage line VCC includes a first working voltage line VCC1 and a second working voltage line VCC2. The first working voltage line VCC1, the first signal line VR, the second signal line VGB, the ground line GND, and the data line DATA extend in a third direction. The second working voltage line VCC2 extends in a fourth direction intersecting with the third direction.

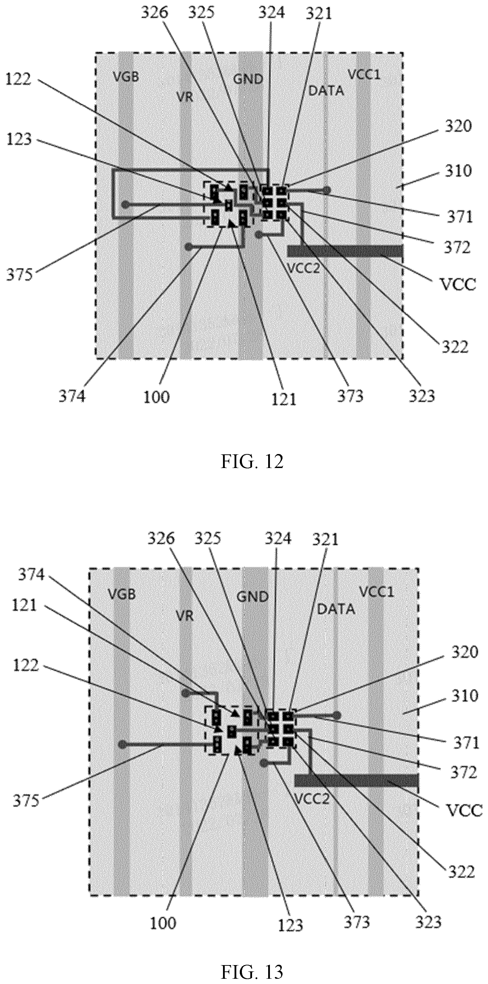

FIG. 12 is a schematic diagram of a part of another display substrate provided by an embodiment of the present disclosure. As shown in FIG. 12, unlike FIG. 10, the display substrate uses the light emitting element shown in FIG. 7.

As shown in FIG. 12, the first output terminal 324 is connected to the second pole of the first light emitting structure 121 (by means of the pad and the connecting electrode described above). The second output terminal 325 is connected to the second pole of the second light emitting structure 122. The third output terminal 326 is connected to the second pole of the third light emitting structure 123. The first signal line VR is connected to the first pole of the first light emitting structure 121 through the fourth connection line 374. The second signal line VGB is connected to the first pole of the second light emitting structure 122 and the first pole of the third light emitting structure 123 through the fifth connection line 375. Thus, the display substrate may omit one connection line. It needs to be noted that the first output terminal of the micro driving chip has to bypass to be connected to the second pole of the first light emitting structure.

FIG. 13 is a schematic diagram of a part of another display substrate provided by an embodiment of the present disclosure. As shown in FIG. 13, unlike FIG. 12, the display substrate uses the light emitting element shown in FIG. 8.

As shown in FIG. 13, the first output terminal 324 is connected to the second pole of the first light emitting structure 121 (by means of the pad and the connecting electrode described above). The second output terminal 325 is connected to the second pole of the second light emitting structure 122. The third output terminal 326 is connected to the second pole of the third light emitting structure 123. The first signal line VR is connected to the first pole of the first light emitting structure 121 through the fourth connection line 374. The second signal line VGB is connected to the first pole of the second light emitting structure 122 and the first pole of the third light emitting structure 123 through the fifth connection line 375. Moreover, the first output terminal of the micro driving chip and the second pole of the first light emitting structure can be connected without bypassing. Thus, the display substrate can reduce the area of the connection lines, thereby improving the light transmittance.

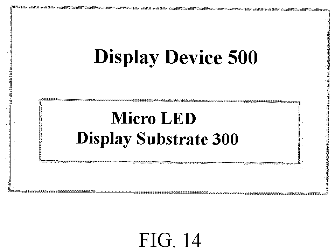

An embodiment of the present disclosure further provides a display device. FIG. 14 is a schematic diagram of a display device provided by an embodiment of the present disclosure. As shown in FIG. 14, the display device 500 includes the display substrate 3100 described above. Thus, the display device has the technical effects corresponding to the beneficial technical effects of a liquid crystal display panel included therein.

For example, the display device may be an electronic product having the display function, such as a television, a display, an electronic picture frame, a digital photo frame, a navigator, a notebook computer, a tablet computer, and a smart phone.

The following points need to be noted:
(1) The accompanying drawings in the embodiments of the present disclosure only involve structures involved in the embodiments of the present disclosure, and other structures may be designed as usual.
(2) Features in the same embodiment and those in different embodiments of the present disclosure may be combined with one another without conflict.

The foregoing are merely descriptions of the specific embodiments of the present disclosure, and the protection scope of the present disclosure is not limited thereto. Any modification or replacement easily conceived of by those skilled in the art within the technical scope of the present disclosure shall fall within the protection scope of the present disclosure. Therefore, the protection scope of the present invention shall be subject to the protection scope of the claims.

## Claims

1. A light emitting element, comprising:
a base substrate;
a plurality of light emitting structures located on the base substrate,
a filling layer located among the plurality of light emitting structures;
a connecting electrode layer located at a side, away from the base substrate, of the filling layer;
an insulating layer located at a side, away from the filling layer, of the connecting electrode layer; and
a plurality of pads located at a side, away from the connecting electrode layer, of the insulating layer,
wherein each of the plurality of light emitting structures comprises a first pole and a second pole; the connecting electrode layer comprises a plurality of connecting electrodes, and each of the plurality of connecting electrodes is connected to the first pole or the second pole of at least one light emitting structure; and
wherein the light emitting element further comprises a plurality of holes located in the insulating layer, and the plurality of pads are connected to the plurality of connecting electrodes through the plurality of holes.

2. The light emitting element according to claim 1, wherein a number of the plurality of light emitting structures is N, and a value range of a number of the plurality of pads is from N+1 to 2N.

3. The light emitting element according to claim 1, wherein a height of each of the plurality of pads relative to the base substrate is greater than a height of the insulating layer relative to the base substrate.

4. The light emitting element according to claim 1, wherein a distance between two adjacent light emitting structures is less than 100 microns.

5. The light emitting element according to any one of claims 1 to 4, wherein an orthographic projection of the connecting electrode on the base substrate is larger than an orthographic projection of the pad connected to the connecting electrode on the base substrate.

6. The light emitting element according to any one of claims 1 to 4, wherein the plurality of light emitting structures comprise a first light emitting structure, a second light emitting structure, and a third light emitting structure;
the first light emitting structure is configured to emit light of a first color; the second light emitting structure is configured to emit light of a second color; and the third light emitting structure is configured to emit light of a third color.

7. The light emitting element according to claim 6, wherein the plurality of connecting electrodes comprise a first connecting electrode, a second connecting electrode, a third connecting electrode, a fourth connecting electrode, a fifth connecting electrode, and a sixth connecting electrode; the plurality of pads comprise a first pad, a second pad, a third pad, a fourth pad, a fifth pad, and a sixth pad;
the first connecting electrode and the second connecting electrode connect the first pole and the second pole of the first light emitting structure to the first pad and the second pad, respectively;
the third connecting electrode and the fourth connecting electrode connect the first pole and the second pole of the second light emitting structure to the third pad and the fourth pad, respectively; and
the fifth connecting electrode and the sixth connecting electrode connect the first pole and the second pole of the third light emitting structure to the fifth pad and the sixth pad, respectively.

8. The light emitting element according to claim 7, wherein the first pad and the second pad are arranged along a first direction; the fifth pad and the sixth pad are arranged along the first direction; the first pad and the fifth pad are spaced apart oppositely in a second direction intersecting with the first direction; the second pad and the sixth pad are spaced apart oppositely in the second direction;
the third pad is located at a side, away from the sixth pad, of the fifth pad; the fourth pad is located at a side, away from the second pad, of the first pad; the third pad and the fourth pad are spaced apart oppositely in the second direction; and
the first light emitting structure, the second light emitting structure, and the third light emitting structure are located between a first connecting line of a center of the second pad and a center of the sixth pad and a second connecting line of a center of the third pad and a center of the fourth pad.

9. The light emitting element according to claim 8, wherein a first gap is provided between the first pad and the fifth pad; a second gap is provided between the second pad and the sixth pad; a third gap is provided between the third pad and the fourth pad; and
the first light emitting structure, the second light emitting structure, and the third light emitting structure are located in a region between the second gap and the third gap.

10. The light emitting element according to claim 8, wherein an area of the first pad is smaller than an area of the second pad; an area of the fifth pad is smaller than an area of the sixth pad; and the first light emitting structure and the third light emitting structure are located between the first pad and the fifth pad.

11. The light emitting element according to claim 10, wherein the second light emitting structure is located between a third connecting line of a center of the first light emitting structure and the center of the third light emitting structure and the second connecting line.

12. The light emitting element according to claim 7, wherein connecting lines of a center of the first light emitting structure, a center of the second light emitting structure, and a center of the third light emitting structure form a triangle.

13. The light emitting element according to claim 7, wherein the first pad, the third pad, and the fifth pad are arranged along a first direction; the second pad, the fourth pad, and the sixth pad are arranged along the first direction;
the first pad and the second pad are spaced apart oppositely in a second direction intersecting with the first direction; the third pad and the fourth pad are spaced apart oppositely in the second direction; the fifth pad and the sixth pad are spaced apart oppositely in the second direction;
the first light emitting structure is located between the first pad and the second pad; the second light emitting structure is located between the third pad and the fourth pad; and the third light emitting structure is located between the fifth pad and the sixth pad.

14. The light emitting element according to claim 13, wherein orthographic projections of the first pad, the second pad, the third pad, the fourth pad, the fifth pad, and the sixth pad on the base substrate are approximately the same in size.

15. The light emitting element according to claim 13, wherein the first pad is connected to the first pole of the first light emitting structure; the third pad is connected to the first pole of the second light emitting structure; the fifth pad is connected to the first pole of the third light emitting structure;
the second pad is connected to the second pole of the first light emitting structure; the fourth pad is connected to the second pole of the second light emitting structure; and the sixth pad is connected to the second pole of the third light emitting structure.

16. The light emitting element according to claim 8, wherein a size of the light emitting element in the first direction is less than or equal to 500 microns.

17. The light emitting element according to claim 6, wherein the plurality of connecting electrodes comprise a first connecting electrode, a second connecting electrode, a third connecting electrode, a fourth connecting electrode, a fifth connecting electrode, and a sixth connecting electrode; the plurality of pads comprise a first pad, a second pad, a third pad, a fourth pad, and a fifth pad;
the first connecting electrode and the second connecting electrode connect the first pole and the second pole of the first light emitting structure to the first pad and the second pad, respectively;
the third connecting electrode and the fourth connecting electrode connect the first pole and the second pole of the second light emitting structure to the third pad and the fourth pad, respectively; and
the fifth connecting electrode and the sixth connecting electrode connect the first pole and the second pole of the third light emitting structure to the third pad and the fifth pad, respectively.

18. The light emitting element according to claim 17, wherein the first pad and the second pad are arranged along a first direction and spaced apart oppositely; the fourth pad and the fifth pad are arranged along the first direction and spaced apart oppositely; the fourth pad and the first pad are spaced apart oppositely in a second direction intersecting with the first direction; the third pad is disposed in a region defined by the first pad, the second pad, the fourth pad, and the fifth pad;
the first light emitting structure is located between the first pad and the second pad; the second light emitting structure is located between the first pad and the fourth pad; and the third light emitting structure is located between the fourth pad and the fifth pad.

19. The light emitting element according to claim 18, wherein the first light emitting structure and the third light emitting structure are located at two sides of the third pad in the second direction, respectively.

20. The light emitting element according to claim 18, wherein a size of the light emitting element in the first direction is less than or equal to 250 microns.

21. The light emitting element according to claim 17, wherein the first pad and the second pad are arranged along a first direction and spaced apart oppositely; the third pad and the fifth pad are arranged along the first direction and spaced apart oppositely; the third pad and the first pad are spaced apart oppositely in a second direction intersecting with the first direction; the fourth pad is disposed in a region defined by the first pad, the second pad, the third pad, and the fifth pad;
the first light emitting structure is located between the first pad and the second pad; the second light emitting structure is located between the first pad and the third pad; and the third light emitting structure is located between the third pad and the fifth pad.

22. The light emitting element according to claim 6, wherein the first color is green color; the second color is red color; and the third color is blue color.

23. A display substrate, comprising:
a driving substrate; and
a plurality of light emitting elements arranged in an array on the driving substrate,
wherein the plurality of light emitting elements comprise the light emitting element according to any one of claims 1 to 22.

24. The display substrate according to claim 23, further comprising:
a plurality of micro driving chips disposed corresponding to the plurality of light emitting elements,
wherein each of the plurality of micro driving chips is configured to drive the corresponding light emitting element to emit light for displaying.

25. The display substrate according to claim 24, wherein the driving substrate comprises a ground line; and an orthographic projection of the light emitting element on the driving substrate overlaps with the ground line.

26. The display substrate according to claim 25, wherein the driving substrate comprises a first signal line, a second signal line, a working voltage line, and a data line; each of the plurality of micro driving chips comprises a data signal terminal, a working voltage terminal, a ground terminal, a first output terminal, a second output terminal, and a third output terminal;
the data signal terminal is connected to the data line through a first connection line; the working voltage terminal is connected to the working voltage line through a second connection line; the ground terminal is connected to the ground line through a third connection line; the first output terminal is connected to the second pole of the first light emitting structure; the second output terminal is connected to the second pole of the second light emitting structure; the third output terminal is connected to the second pole of the third light emitting structure;
the first signal line is connected to the first pole of the first light emitting structure through a fourth connection line; the second signal line is connected to the first pole of the second light emitting structure through a fifth connection line; and the second signal line is connected to the first pole of the third light emitting structure through a sixth connection line.

27. A display device, comprising the display substrate according to any one of claims 23 to 26.
